# EUROPEAN PATENT SPECIFICATION

(11) **EP 3 035 065 B1**
(45) Date of publication and mention of the grant of the patent: **08.04.2020**
(21) Application number: 15186204.2
(22) Date of filing: 22.09.2015
(51) Int. Cl.: G01R 31/02

(54) **DEVICE FOR TESTING CONTROL TRANSFORMERS**
GERÄT ZUR PRÜFUNG VON STEUERTRANSFORMATOREN
DISPOSITIF POUR TESTER DES TRANSFORMATEURS DE COMMANDE

(30) Priority: 28.11.2014 CZ 20140827
(43) Date of publication of application: 22.06.2016
(73) Proprietor: Ceske vysoke uceni technicke v Praze, 160 00 Praha 6 - Dejvice (CZ)
(72) Inventor: Papez, Vaclav, 10000 Praha 10 (CZ)
(74) Representative: Kratochvil, Vaclav

(56) References cited:
- EP-A1- 1 398 644
- EP-A2- 1 275 971
- US-A- 2 634 318
- US-A- 2 896 156
- US-A- 4 857 827
- US-A1- 2012 139 555

## Description

### Background of the Invention

Presented solution deals with a device for testing control transformers, which is a type of transformers used for supplying power to control circuits. In comparison with common mains transformers they are subject to higher level requirements because they serve, among other aspects, to supply power to devices with tripping solenoids, such as contactors.

### Description of Prior Art

An important quality in testing control transformers is the permissible instantaneous power of the transformer, which is defined as the maximum apparent power that can be connected to the secondary winding of the transformer and causes the output voltage drop not greater than 5% of the nominal value, while maintaining other conditions.

The test simulates for the transformer a condition where to the transformer, which is loaded and heated to a stabilized temperature, is connected another device with tripping solenoid. In such device's solenoid the magnetic circuit is open and the solenoid, for a short time before the armature operation occurs, draws from the transformer high apparent power. At the same time, the transformer output voltage must not drop to the extent that the operation of the lastly connected solenoid would fail, or that the previously operated armatures of solenoids connected to the transformer would fall apart.

Measuring of the permissible instantaneous power of the transformer is in principle a measurement of the output voltage of the transformer under defined load.

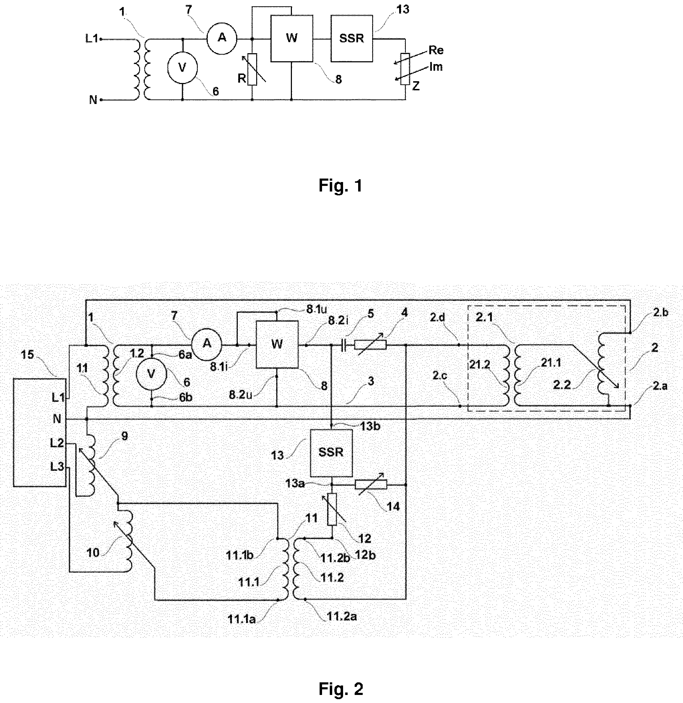

In an idealized case, for a transformer with one primary and secondary winding, the measurement may be performed in the circuit according to Fig. 1. Tested transformer 1 is supplied at its primary terminals by standardized mains voltage.

The loading circuit on the secondary winding of the tested transformer 1 has two branches. The first one is a branch with variable active resistor R and the second branch includes variable impedance forming a load Z, for which both the real and imaginary components of this impedance can be adjusted.

In a common case, if the transformer's nominal thermal power is active, it can be usually set during testing with sufficient accuracy by the variable active resistor R in the first branch based on information from the voltmeter 6 and the ammeter 7. However, finding a stabilized state at temperature balance may be difficult because during warming up the winding's ohmic resistance of the tested transformer 1 keeps changing and these changes must be compensated for by changing the load Z.

The second branch with variable impedance serves for setting the loading apparent power of the tested transformer 1 when measuring its permissible instantaneous power. Setting of the required apparent loading power of the tested transformer 1, with respect to the magnitude of the power factor, is in principle possible by the applied variable load Z, where it is possible to control both its real and imaginary components based on information provided by the voltmeter 6, ammeter 7 and wattmeter 8.

Loading impedance is connected to the circuit of the tested transformer 1 by means of a special switch, for example the solid state relay 13, which allows to connect the load Z by suitably selected method that will be followed during each switching. The measurement however may be rather complicated. This is caused by the fact that the measurement is carried out with current in the tested transformer 1 winding that many times, usually three times, exceeds the nominal current and the measurement, according to conditions defined by a standard, must be performed within 50 ms after attaching the measuring load Z to eliminate distortion caused by subsequent warming up of the tested transformer 1 winding. Therefore, as the ammeter 7, voltmeter 6 and wattmeter 8 digital measuring instruments must be used, which as a minimum allow for synchronized readout of the effective (RMS) values of voltage and current and the mean value of active power during a single period, or at least a digital memory oscilloscope allowing mathematic processing of the recorded conditions data.

However, setting the load Z according to the required power of the tested transformer 1 and the output voltage readout of the tested transformer 1 within such a short period are complicated. When the settings are made during several cycles, between which the tested transformer 1 is unloaded and cools down, it is possible to reach the setting based on valid measured values. But the time required for the measurement is many times longer.

Other difficulties are caused also by instable mains voltage and its distortion on the primary side of the tested transformer 1 because eventually the measurement may in fact be carried out under different input parameters than those, for which the measurement conditions were set.

Further complications during the equipment implementation, especially the high-power equipment, are caused also by implementation of adjustable variable loads for powers in hundreds or even thousands W or VA, which must be sufficiently robust and must be adequately cooled to ensure that the set parameters will be maintained constant during operation. Prior art document US 2896 156 A discloses a circuit for testing transformers by using synthesized load conditions.

### Summary of the Invention

Disadvantages mentioned above are removed by a device for testing control transformers according to the presented solution. This device contains measuring circuit consisting of voltmeter, ammeter and wattmeter. The voltmeter is connected by its first terminal together with the first terminal of the secondary winding of the measured transformer to the grounding bus of the measuring circuit. Transformer's second terminal together with the second terminal of the secondary winding of the measured transformer is connected via the ammeter to the first terminals of the wattmeter's voltage and current circuits. The second terminal of the wattmeter voltage circuit is connected to the grounding bus of the measuring circuit. The principle of the new solution is that the second terminal of the wattmeter's current circuit is connected via the compensating capacitor to the first end of the first adjustable resistor. The second end of the first adjustable resistor is connected to the second terminal of the output circuit of the voltage recovery source, while its first terminal is connected to the grounding bus of the measuring circuit. The first terminal of the input circuit of the voltage recovery source is together with the first terminal of the primary winding of the measured transformer connected to the neutral terminal of the three-phase power supply source. The second terminal of the input circuit of the voltage recovery source together with the second terminal of the primary winding of the measured transformer is connected to the first phase terminal of the three-phase power supply source. The second terminal of the output circuit of the voltage recovery source is then together with the first end of the second adjustable resistor connected to the first terminal of the secondary winding of the isolating transformer, and the second terminal of this transformer is connected to the first end of the third adjustable resistor. The second end of the third adjustable resistor is together with the second end of the second adjustable resistor connected to the first terminal of the solid state relay. The second terminal of this relay is connected to the second terminal of the wattmeter's current circuit. The second terminal of the primary winding of the isolating transformer is connected to the slider of the first regulating transformer, while its winding is connected between the neutral terminal of the three-phase power supply source and the second phase terminal of the three-phase power supply source. The first terminal of the primary winding of the isolating transformer is connected to the slider of the second regulating transformer, while its winding is connected between the slider of the first regulating transformer and the third phase terminal of the three-phase power supply source.

According to the preferred embodiment the voltage recovery source is realized by an additional transformer, which is identical with the measured transformer, and by the third regulating transformer. Secondary winding of this additional transformer forms the output circuit of the voltage recovery source. Primary winding of this additional transformer is connected to the output of the third regulating transformer, while its winding is connected as the input circuit of the voltage recovery source.

In a realization example, the above-mentioned additional transformer and the third regulating transformer are realized by one transformer with separate windings for the input and output circuits of the voltage recovery source sized for two to three times higher power than the power of the measured transformer, while the secondary voltage is roughly by 10% lower than the secondary voltage of the measured transformer.

The advantage of the presented solution is that it allows for easy and fast testing of transformers for permissible instantaneous power of the transformer.

Another advantage is that the power loading the transformer may be recovered back to the mains without being dissipated. Recovery will significantly reduce the electric power consumption of the testing device and will also reduce cost of the testing device implementation because it will not dissipate high powers.

### Explanation of Drawings

Fig. 1 shows diagram of the device for testing control transformers corresponding to the state of art known so far. Example of connection of the device according to the new solution is shown in Fig. 2.

### Detailed Description of the Preferred Embodiment

As already mentioned above, the main objective is implementation of a device, which allows for easy and fast testing of transformers for their permissible instantaneous power. To achieve this it is in particular necessary that the prescribed defined permanent load of the transformer as well as the prescribed defined short-term load may be set independently or at least with minimum influence of the short-term load on the set permanent load, and that the short-term load may be set with minimum influence of the magnitude of apparent power on its power factor. For example for active permanent load, this can be achieved by loading the transformer by an impedance consisting of capacitor and resistor, where the capacitor is sized in such a way to compensate the leakage inductance of transformer, and then the resistor value, actually without any impact on the power factor, sets the active power of the load. Transformer load corresponding to the prescribed defined short-term load may be realized for example in such a way that the secondary winding of the transformer will simply not be loaded for this purpose by an adjustable impedance but the current loading the transformer will be realized by passing the current through a conductive member connected between the first end of the secondary winding of the transformer and the first terminal of the reference voltage source, while its second terminal is connected to the second end of the secondary winding of the transformer. Setting the phase shift between the vector of the voltage difference between the voltage source and the voltage at the transformer winding and the vector of the voltage at the transformer winding defines the load power factor, and the value of the connected conductive member or the value of vector of the voltage difference between the voltage source and voltage at the transformer winding allow to set the apparent current of loads actually without impacting its power factor.

The device must also allow for easy and full automation of measurement. Values readout under short-term loads of the transformer can under all circumstances be performed only by a digital measuring instrument or at least by quality digital memory oscilloscope because the measurement requires fast readout of the transformer voltage and the prescribed defined setting of the short-term load, which during such time slot cannot be ensured otherwise. In case the digital measuring instrument will allow to control the adjustable loads towards reaching the parameters prescribed and defined for the test, the device will operate fully automatically.

It is also advantageous if the power loading the transformer may be recovered back to mains without being dissipated by the loads. Recovery will significantly reduce the electric power consumption of the testing device and will also reduce cost of the testing device implementation because it will use loads only in fractions of powers that load the transformer under testing.

Schematic diagram of the analogue measuring device according to the presented solution is shown in Fig. 2. This device for testing control transformers contains measuring circuit consisting of voltmeter 6, ammeter 7 and wattmeter 8 like in the example in Fig. 1. The voltmeter 6 is connected by its first terminal together with the first terminal of the secondary winding of the tested transformer 1 to the grounding bus 3 of the measuring circuit. The second terminal of the voltmeter 6 together with the second terminal of the secondary winding of the tested transformer 1 is connected via the ammeter 7 to the first terminals of the wattmeter 8 voltage and current circuits. The second terminal of the wattmeter 8 voltage input is connected to the grounding bus 3 of the measuring circuit and the second terminal of its current circuit is connected via the compensating capacitor 5 to the first end of the first adjustable resistor 4. The second end of the first adjustable resistor 4 is connected to the second terminal of the output circuit of the voltage recovery source 2. The first terminal of the voltage recovery source 2 is connected to the grounding bus 3 of the measuring circuit. The first terminal of the input circuit of the voltage recovery source 2 is together with the first terminal of the primary winding of the tested transformer 1 connected to the neutral terminal N of the three-phase power supply source 15. The second terminal of the input circuit of the voltage recovery source 2 together with the second terminal of the primary winding of the tested transformer 1 is connected to the first phase terminal L1 of the three-phase power supply source 15. The second terminal of the output circuit of the voltage recovery source 2 is then together with the first end of the second adjustable resistor 14 connected to the first terminal of the secondary winding of the isolating transformer 11. The second terminal of the secondary winding of the isolating transformer 11 is connected to the first end of the third adjustable resistor 12, while its second end is together with the second end of the second adjustable resistor 14 connected to the first terminal of the solid state relay 13. The second terminal of this solid state relay 13 is connected to the second terminal of the current circuit of the wattmeter 8. The second terminal of the primary winding of the isolating transformer 11 is connected to the slider of the first regulating transformer 9. Winding of the first regulating transformer 9 is connected between the neutral terminal N of the three-phase power supply source 15 and the second phase terminal L2 of the three-phase power supply source 15. The first terminal of the primary winding of the isolating transformer 11 is connected to the slider of the second regulating transformer 10, while its winding is connected between the slider of the first regulating transformer 9 and the third phase terminal L3 of the three-phase power supply source 15.

The voltage recovery source 2 is realized by an additional transformer 2.1 identical with the tested transformer 1, and the third regulating transformer 2.2. Secondary winding of this additional transformer 2.1 then forms the output circuit of the voltage recovery source 2. Its primary winding is connected to the output of the third regulating transformer 2.2, while its winding is connected as the input circuit of the voltage recovery source 2. In a realization example, the above-mentioned additional transformer 2.1 and the third regulating transformer 2.2 forming the voltage recovery source 2 are realized by a single transformer with separate windings for the input and output circuits sized for two to three times higher power than the power of the tested transformer 1, while the secondary voltage is roughly by 10% lower than the voltage of the tested transformer 1.

The device, even if it is used for testing a single-phase transformer only, is supplied by the three-phase power mains. This allows to generate in the device the required measuring and reference voltages, while their values and phase shifts are much more stable than when phase shifters are used.

Below is described the function for the case when the recovery source is formed by two transformers, the transformer 2.1, an additional transformer technically identical with the tested transformer, and the third regulating transformer 2.2.

Secondary windings of the tested transformer 1 and the additional transformer 2.1 are mutually connected by their first ends directly in such a way that the voltages against this node at their second ends are in phase. Against the value of voltages at the secondary windings of the tested transformer 1 and the additional transformer 2.1, the difference of voltages between the second ends of these first windings is only a fraction, approximately 10%, of the value of the voltage at the secondary winding of the tested transformer 1. This allows to reach the condition that when the tested transformer 1 is loaded by the resistor connected between the winding of the tested transformer 1 and the additional transformer 2.1, the only power lost in it is the power given by the drawn current and the difference voltage; roughly 90% of power under permanent load returns via the additional transformer 2.1 and the third regulating transformer 2.2 back to the primary circuit of the tested transformer 1. Value of the loading power can be set precisely either by the size of the load resistance formed by the first adjustable resistor 4, or by precise setting of the output voltage of the third regulating transformer 2.2. It is however necessary that the applied value of the first adjustable resistor 4 was several times higher than the internal resistance of the equivalent voltage sources representing the secondary side of the tested transformer 1 and the additional transformer 2.1. Compliance with this condition is necessary to reduce the influence of the transformer winding resistance, which is strongly temperature dependent, on the current flow. Influence of the leakage inductance is compensated by the capacitor 5, the capacitance of which is chosen so that its reactance value was the same size as the leakage inductance reactance. Since the leakage inductance of the tested transformers is usually small, for perfect function of the compensation circuit it is usually sufficient to observe the compensating condition with the accuracy better than about 10%; the capacitor has very high capacity and it is loaded by only very low voltage. To the terminals of the secondary winding of the tested transformer 1 are further connected the measuring instruments - voltmeter 6, ammeter 7 and wattmeter 8 - allowing to determine the voltage and apparent and active powers at the terminals of the transformer secondary winding. In the experimental version of the measuring device the voltmeter 6 and the ammeter 7 are realized by both the pointer measuring instruments and digital memory oscilloscope with the current and voltage probes, and the wattmeter 8 is realized by the pointer measuring instrument. Pointer measuring instruments allow for easy setting of the measurement parameters in the temperature-balanced mode; evaluation of voltages and currents recorded by the memory oscilloscope allows to determine the values measured in the limited time shortly after connecting the short-term load.

The reference voltage source for loading the tested transformer 1 by the short-term load is realized by the first regulating transformer 9, the second regulating transformer 10 and the isolating transformer 11. Transformer 11 is primarily an isolating transformer. Preferably it has such transformation ratio that the maximum settable voltage at its secondary winding reaches about 30% of the output voltage of the tested transformer 1. Specific value of this voltage is set by the slider of the transformer 10. Position of the slider of the first regulating transformer 9 sets the phase of the reference voltage. In the circuit according to the diagram, the settable value of phase shifts ranges approximately from 60 to 90° against the voltage in the phase line L1; setting of the phase shift affects also the setting of the reference voltage value. Between the secondary winding of the isolating transformer 11 and the secondary windings of the tested transformer 1 and the additional transformer 2.1 is connected a circuit, which serves for setting the short-term power load of the tested transformer 1. The first terminal of the secondary winding of the isolating transformer 11 is directly connected to the second terminal of the secondary winding of the additional transformer 2.1, the second terminal of the isolating transformer 11 is via the third adjustable resistor 12 and the solid state relay 13 connected to the output of the wattmeter 8 and further via the ammeter 7 to the second terminal of the tested transformer 1. When the solid state relay 13 trips, in this circuit flows current, the size of which can be set by the value of the third adjustable resistor 12 or by setting the value of the secondary voltage of the isolating transformer 11, its phase shift against the voltage at the secondary winding of the tested transformer 1 can be set by position of the slider of the first regulating transformer 9. Between the second terminal of the additional transformer 2.1 and the node connecting the solid state relay 13 and the third adjustable resistor 12 is connected the second adjustable resistor 14 and its setting adjusts the size of nominal thermal power drawn from the tested transformer 1 under simultaneous short-term load in case when the load of the tested transformer 1 or the voltage recovery source 2 by the short-term load causes significant change of this power.

### Industrial Applicability

Device for testing control transformers according to the presented solution may be implemented in all cases when transformers are tested for permissible instantaneous power or by other methodologies that require to determine immediate influence of the transformer output load change on its output voltage.

## Claims

1. The device for testing control transformers containing
a three-phase power supply source (15) with a first phase terminal (L1) and a neutral terminal (N) for a connection of a primary winding (1.1) of a control transformer (1) to be tested;
a measuring circuit having a ground bus (3) and consisting of a voltmeter (6) for a parallel connection to a secondary winding (1.2) of the control transformer (1) to be tested, an ammeter (7) and wattmeter (8), where the voltmeter (6) is connected by its first terminal (6b) to the grounding bus (3) of the measuring circuit, while the second terminal (6a) of the voltmeter (6) is connected via the ammeter (7) to the first terminal (8.1u) of the wattmeter (8) voltage circuit and to the first terminal (8.1i) of the wattmeter (8) current circuit while the second terminal (8.2u) of the wattmeter (8) voltage circuit is connected to the grounding bus (3) of the measuring circuit; a voltage recovery source (2) and
a circuit containing a compensating capacitor (5) and a first adjustable resistor (4) and the device for testing control transformers further containing a first regulating transformer (9), a second regulating transformer (10), an isolating transformer (11), a second adjustable resistor (14), a third adjustable resistor (12) and a solid state relay (13), where the second terminal (8.2i) of the wattmeter (8) current circuit is connected via the compensating capacitor (5) to the first end of the first adjustable resistor (4), while the second end of the first adjustable resistor (4) is connected to the second terminal (2d) of the output circuit of the voltage recovery source (2), where the first terminal (2c) of the output voltage recovery source (2) is connected to the grounding bus (3) of the measuring circuit, and where the first terminal (2a) of the input circuit of the voltage recovery source (2) is connected to the neutral terminal (N) of the three-phase power supply source (15) and the second terminal (2b) of the input circuit of the voltage recovery source (2) is connected to the first phase terminal (L1) of the three-phase power supply source (15), while the second terminal (2d) of the output circuit of the voltage recovery source (2) is further connected, together with the first end of the second adjustable resistor (14), to the first terminal (11.2a) of the secondary winding (11.2) of the isolating transformer (11), whose second terminal (11.2b) of the secondary winding (11.2) is connected to the first end of the third adjustable resistor (12), whose second end is connected, together with the second end of the second adjustable resistor (14), to the first terminal (13.a) of the solid state relay (13), which is connected by its second terminal (13b) to the second terminal (8.2i) of the current circuit of the wattmeter (8), while the second terminal (11.1b) of the primary winding (11.1) of the isolating transformer (11) is connected to the slider of the first regulating transformer (9), whose winding is connected between the neutral terminal (N) of the three-phase power supply source (15) and the second phase terminal (L2) of the three-phase power supply source (15); and the first terminal (11.1a) of the primary winding (11.1) of the isolating transformer (11) is connected to the slider of the second regulating transformer (10), whose winding is connected between the slider of the first regulating transformer (9) and the third phase terminal (L3) of the three-phase power supply source (15), while the voltage recovery source (2) is realized by an additional transformer (2.1) identical with the tested transformer (1), while the secondary winding of this additional transformer (2.1) forms the output circuit of the voltage recovery source (2) and the primary winding (2.1.1) of the transformer (2.1) is connected to the output of the third regulating transformer (2.2), whose winding is connected as the input circuit of the voltage recovery source (2).

## Patentansprüche

1. Einrichtung zur Prüfung von Steuertransformatoren umfassend
Dreiphasen-Stromversorgung (15) mit erster Phasenklemme (L1) und Nullklemme (N) zum Anschluss der Primärwicklung (1.1) des geprüften Steuertransformators (1),
Messkreis mit Bus (3) und bestehend aus einem Spannungsmesser (6) für den Parallelanschluss zur Sekundärwicklung (1.2) des geprüften Steuertransformators (1), Strommesser (7) und Leistungsmesser (8), wo der Spannungsmesser (6) mit seiner ersten Klemme (6b) mit dem Bus (3) des Messkreises verbunden ist und dessen zweite Klemme (6a) über den Strommesser (7) mit der ersten Klemme (8.1u) des Spannungskreises des Leistungsmessers (8) und mit der ersten Klemme (8.1i) des Stromkreises des Leistungsmessers (8) verbunden ist, wo die zweite Klemme (8.2u) des Spannungskreises des Leistungsmessers (8) mit dem Bus (3) des Messkreises verbunden ist, Rekuperation-Spannungsquelle (2), und
Kreis umfassend Kompensationskondensator (5), ersten einstellbaren Widerstand (4) und die Einrichtung zur Prüfung von Steuertransformatoren umfasst weiterhin ersten Regulierungstransformator (9), zweiten Regulierungstransformator (10), Trenntransformator (11), zweiten einstellbaren Widerstand (14), dritten einstellbaren Widerstand (12) und ein Halbleiterrelais (13), wo die zweite Klemme (8.2i) des Stromkreises des Leistungsmessers (8) über den Kompensationskondensator (5) mit einem Ende des ersten einstellbaren Widerstands (4) verbunden ist, dessen zweites Ende mit der zweiten Klemme (2d) der Ausgangsschaltung der Rekuperation-Spannungsquelle (2) verbunden ist, wo die erste Klemme (2c) der Ausgangsschaltung der Rekuperation-Spannungsquelle (2) mit dem Bus (3) des Messkreises verbunden ist und wo die erste Klemme (2a) der Eingangsschaltung der Rekuperation-Spannungsquelle (2) mit der Nullklemme (N) der Dreiphasen-Stromversorgung (15) verbunden ist und die zweite Klemme (2b) der Eingangsschaltung der Rekuperation-Spannungsquelle (2) mit der ersten Phasenklemme (L1) der Dreiphasen-Stromversorgung (15) verbunden ist, wobei die zweite Klemme (2d) der Ausgangsschaltung der Rekuperation-Spannungsquelle (2) weiterhin zusammen mit einem Ende des zweiten einstellbaren Widerstands (14) mit der ersten Klemme (11.2a) der Sekundärwicklung (11.2) des Trenntransformators (11) verbunden ist, dessen zweite Klemme (11.2b) der Sekundärwicklung (11.2) mit einem Ende des dritten einstellbaren Widerstands (12) verbunden ist, dessen zweites Ende zusammen mit dem zweiten Ende des zweiten einstellbaren Widerstands (14) mit der ersten Klemme (13.a) des Halbleiterrelais (13) verbunden ist, das mit seiner zweiten Klemme (13b) mit der zweiten Klemme (8.2i) des Stromkreises des Leistungsmessers (8) verbunden ist, wobei die zweite Klemme (11.1b) der Primärwicklung (11.1) des Trenntransformators (11) mit dem Läufer des ersten Regulierungstransformators (9) verbunden ist, dessen Wicklung zwischen der Nullklemme (N) der Dreiphasen-Stromversorgung (15) und der zweiten Phasenklemme (L2) der Dreiphasen-Stromversorgung (15) angeschlossen ist und die erste Klemme (11.1a) der Primärwicklung (11.1) des Trenntransformators (11) mit dem Läufer des zweiten Regulierungstransformators (10) verbunden ist, dessen Wicklung zwischen dem Läufer des ersten Regulierungstransformators (9) und der dritten Phasenklemme (L3) der Dreiphasen-Stromversorgung (15) angeschlossen ist, wobei die Rekuperation-Spannungsquelle (2) durch einen weiteren Transformator (2.1) realisiert ist, der mit dem getesteten Steuertransformator (1) identisch ist, wobei die Sekundärwicklung des weiteren Transformators (2.1) die Ausgangsschaltung der Rekuperation-Spannungsquelle (2) bildet, und wo die Primärwicklung (2.1.1) des Transformators (2.1) am Ausgang des dritten Regulierungstransformators (2.2) angeschlossen ist, dessen Wicklung als Eingangsschaltung der Rekuperation-Spannungsquelle (2) angeschlossen ist.

## Revendications

1. Dispositif d'essai des transformateurs de commande comprenant:
une source (15) d'alimentation triphasée avec une première borne (L1) de phase et une borne (N) neutre pour connecter l'enroulement (1.1) primaire du transformateur (1) de commande testé,
un circuit de mesure avec une barre (3) collectrice de mise à la terre et composé d'un voltmètre (6) destiné à être connecté en parallèle à l'enroulement (1.2) secondaire du transformateur (1) de commande testé, d'un ampèremètre (7) et d'un wattmètre (8), où la première borne (6b) du voltmètre (6) est connecté à la barre (3) collectrice de mise à la terre du circuit de mesure et la deuxième borne (6a) est connectée via l'ampèremètre (7) à la première borne (8.1u) du circuit de tension du wattmètre (8) et à la première borne (8.1i) du circuit de courant du wattmètre (8), où la deuxième borne (8.2u) du circuit de tension du wattmètre (8) est connectée à la barre (3) collectrice de mise à la terre du circuit de mesure, une source (2) de tension récupératrice, et
un circuit comprenant un condensateur (5) de compensation, une première résistance (4) réglable, et le dispositif d'essai des transformateurs de commande comprend en outre un premier transformateur (9) de régulation, un deuxième transformateur (10) de régulation, un transformateur (11) d'isolement, une deuxième résistance (14) réglable, une troisième résistance (12) réglable et un relais (13) à semi-conducteur où la deuxième borne (8.2i) du circuit de courant du wattmètre (8) est connectée via un condensateur (5) de compensation à une extrémité de la première résistance (4) réglable dont la deuxième extrémité est connectée à la deuxième borne (2d) du circuit de sortie de la source (2) de tension récupératrice, où la première borne (2c) du circuit de sortie de la source (2) de tension récupératrice est connectée à la barre (3) collectrice de mise à la terre du circuit de mesure, et où la première borne (2a) du circuit d'entrée de la source (2) de tension récupératrice est connectée à la borne (N) neutre de la source (15) d'alimentation triphasée et la deuxième borne (2b) du circuit d'entrée de la source (2) de tension récupératrice est connectée à la première borne (L1) de phase de la source (15) d'alimentation triphasée, la deuxième borne (2d) du circuit de sortie de la source (2) de tension récupératrice avec une extrémité de la deuxième résistance (14) réglable étant également connectée à la première borne (11.2a) de l'enroulement secondaire (11.2) du transformateur d'isolement (11) dont la deuxième borne (11.2b) de l'enroulement secondaire (11.2) est connectée à une extrémité de la troisième (12) résistance réglable dont l'autre extrémité, avec l'autre extrémité de la deuxième résistance (14) réglable, est connectée à la première borne (13.a) du relais (13) à semi-conducteur qui est connectée par sa deuxième borne (13b) à la deuxième borne (8.2i) du circuit de courant du wattmètre (8), la deuxième borne (11.1b) de l'enroulement (11.1) primaire du transformateur (11) d'isolement étant connectée au curseur du premier transformateur (9) de régulation dont l'enroulement est connecté entre la borne (N) neutre de la source (15) d'alimentation triphasée et la deuxième borne (L2) de phase de la source (15) d'alimentation triphasée et la première borne (11.1a) de l'enroulement primaire (11.1) du transformateur (11) d'isolement est connectée au curseur du deuxième transformateur (10) de régulation dont l'enroulement est connecté entre le curseur du premier transformateur (9) de régulation et la troisième borne (L3) de phase de la source (15) d'alimentation triphasée, la source (2) de tension récupératrice étant réalisée par un autre transformateur (2.1) identique au transformateur (1) de commande testé, étant à l'enroulement secondaire de l'autre (2.1) transformateur le circuit de sortie de la source (2) de tension récupératrice et où l'enroulement (2.1.1) primaire du transformateur (2.1) est connecté à la sortie d'un troisième transformateur (2.2) de régulation dont l'enroulement est connecté en tant que circuit d'entrée de la source (2) de tension récupératrice.
